## Europäisches Patentamt
## European Patent Office
## Office européen des brevets

(19)

(11) Veröffentlichungsnummer : **0 011 087**
**B1**

(12)

# EUROPÄISCHE PATENTSCHRIFT

(45) Veröffentlichungstag der Patentschrift :
23.12.81

(21) Anmeldenummer : 79102789.9

(22) Anmeldetag : 03.08.79

(51) Int. Cl.³ : **G 08 B 13/22**, B 60 R 25/10,
G 08 B 21/00, G 01 P 15/08//
G01C9/00, G01R17/10

(54) **Alarmanlage, insbesondere für Kraftfahrzeuge.**

(30) Priorität : 02.11.78 DE 2847448
31.03.79 DE 2913018

(43) Veröffentlichungstag der Anmeldung :
28.05.80 (Patentblatt 80/11)

(45) Bekanntmachung des Hinweises auf die Patenterteilung : 23.12.81 Patentblatt 81/51

(84) Benannte Vertragsstaaten :
DE FR GB IT

(56) Entgegenhaltungen :
DE - A - 2 515 257
DE - A - 2 633 411
FR - A - 2 369 542
GB - A - 614 229
US - A - 3 164 023
US - A - 3 290 786
US - A - 3 715 006
US - A - 3 843 539
US - A - 3 925 756
US - A - 4 010 444

(73) Patentinhaber : ROBERT BOSCH GMBH
Postfach 50
D-7000 Stuttgart 1 (DE)

(72) Erfinder : Huber, Bernd, Dr., Dipl.-Ing.
Dammweg 14
D-8501 Altenberg (DE)
Erfinder : Schneider, Erich, Dipl.-Ing.
Entengasse 14
D-7125 Kirchheim (DE)
Erfinder : Fleischer, Helmut
Augasse 20
D-6361 Niddatal (DE)

EP 0 011 087 B1

Alarmanlage, insbesondere für Kraftfahrzeuge

## Stand der Technik

Die Erfindung geht aus von einer Alarmanlage nach der Gattung der Ansprüche 1 und 3. Es ist schon eine solche Alarmanlage aus der US-A 3 925 756 bekannt, bei der jedoch die Gefahr besteht, daß kurzzeitige Erschütterungen, wie sie z.B. durch Schaukeln der Karosserie eines Kraftfahrzeugs durch Kinder oder Windstöße verursacht sein können, den Alarm auszulösen vermögen. Weiterhin besteht die Gefahr, daß auch sehr langfristige Veränderungen der Lage, wie dies z.B. beim Schmelzen einer Schneelast der Fall sein kann, zum unerwünschten Auslösen eines Alarms führen können.

Als Lagesensor ist aus der US-A- 3 843 539 ein mit einer leitfähigen Flüssigkeit gefülltes Gefäß bekannt, in dem Elektroden je nach Lage mehr oder weniger in dieser Flüssigkeit eintauchen. Die sich ergebende Widerstandsänderung wird als Lagesignal ausgewertet.

Die Speicherung eines Werts kann in analoger oder gemäß der US-A 3 715 006 in digitaler Form erfolgen.

## Vorteile der Erfindung

Die erfindungsgemäße Alarmanlage mit den kennzeichnenden Merkmalen des Anspruchs 1 hat den Vorteil, daß bei sehr kurzzeitigen Lageänderungen kein unerwünschter Alarm ausgelöst wird.

Auch durch die kennzeichnenden Merkmale des unabhängigen Anspruchs 3 wird eine unerwünschte Alarmauslösung bei Sonderbedingungen verhindert, indem dort diese Auslösung bei sehr langfristigen Veränderungen der Lage verhindert wird.

Durch die in den abhängigen Ansprüchen aufgeführten Maßnahmen sind vorteilhafte Weiterbildungen und Verbesserungen der in den Ansprüchen 1 und 3 angegebenen Alarmanlage möglich. Besonders vorteilhaft ist die Ausbildung des Lagesensors als Kurzschlußringgeber mit einem drehbar um eine Achse gelagerten Kurzschlußring, da hierbei eine Lageänderung sehr präzise erfaßt und direkt ein digitaler Lagewert erzeugt werden kann.

## Zeichnung

Ausführungsbeispiel der Erfindung sind in der Zeichnung dargestellt und in der nachfolgenden Beschreibung näher erläutert. Es zeigen Fig. 1 ein erstes Ausführungsbeispiel der Erfindung mit einer teils analogen, teils digitalen Schaltungsausführung, Fig. 2 ein Signaldiagramm zur Erläuterung der Wirkungsweise, Fig. 3 ein zweites Ausführungsbeispiel in digitaler Schaltungsausführung und Fig. 4 ein weiteres Ausführungsbeispiel eines Lagesensors mit Lageauswertschaltung.

## Beschreibung der Ausführungsbeispiele

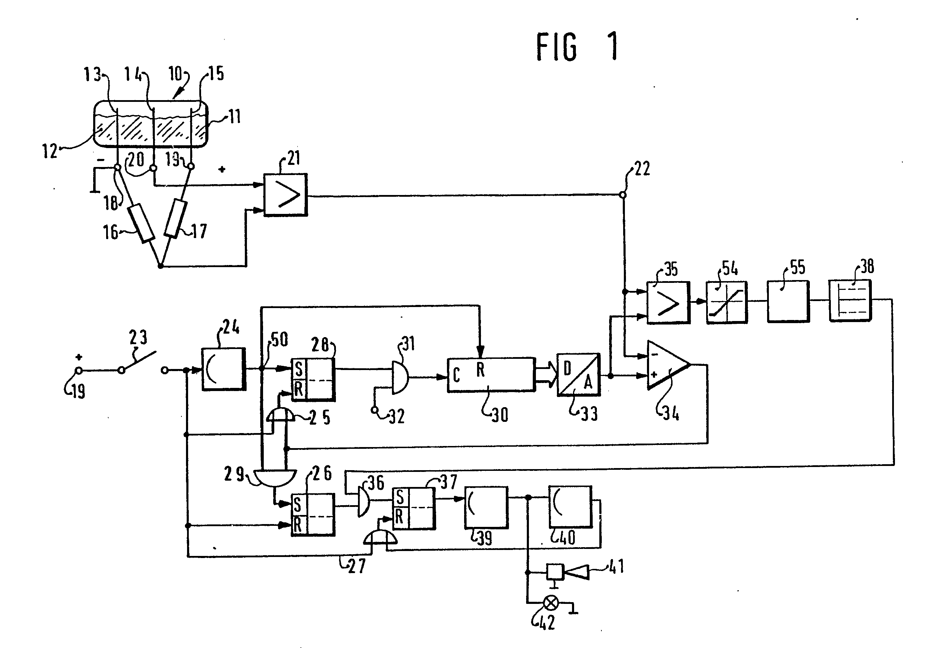

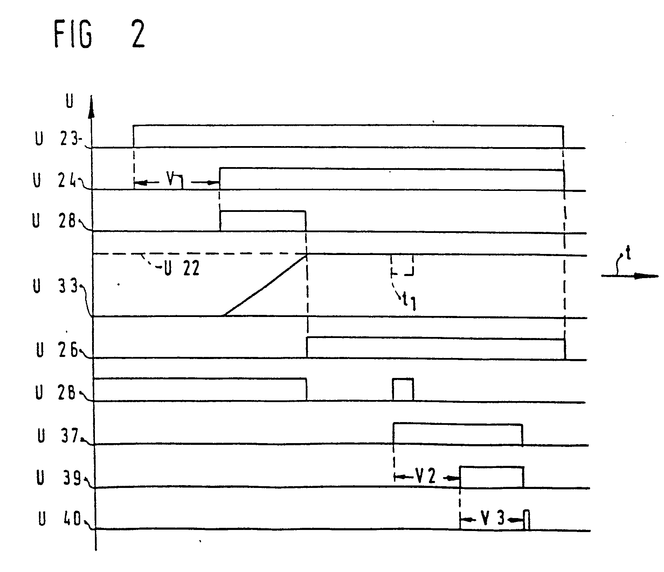

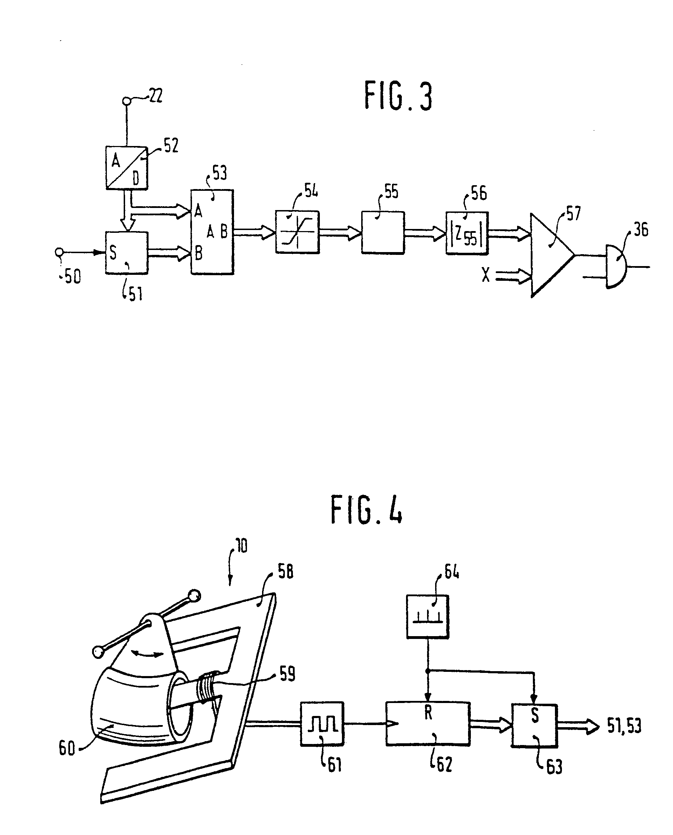

In dem in Fig. 1 dargestellten ersten Ausführungsbeispiel besteht ein Lagesensor 10 aus einem Behälter 11, der teilweise mit einer Flüssigkeit 12 gefüllt ist. In diese Flüssigkeit ragen drei Elektroden 13 bis 15, die je nach Lage, bzw. Neigung des Lagesensors 10 mehr oder weniger von der Flüssigkeit 12 benetzt sind. In Abhängigkeit von der Benetzung, also in Abhängigkeit des Anteils der Elektrode, der sich in der Flüssigkeit befindet, ändert sich der ohmsche Widerstand zwischen zwei Elektroden. Neigt sich der Lagesensor 10 z.B. nach rechts, so bleibt der benetzte Teil der mittleren Bezugselektrode 14 gleich, während die Elektrode 13 zu einem geringeren Teil und die Elektrode 15 zu einem größeren Teil benetzt wird. Der Widerstandswert zwischen den Elektroden 13, 14 steigt an, während der Widerstandswert zwischen den Elektroden 14, 15 fällt. Die somit gebildeten beiden variablen Widerstände 13, 14 bzw. 14, 15 sind zusammen mit zwei Widerständen 16, 17 als Widerstands-Brücke geschaltet. Dabei ist eine sowohl mit der Elektrode 13 wie auch mit dem Widerstand 16 verbundene Klemme 18 an Masse und eine sowohl an die Elektrode 15 wie auch an den Widerstand 17 angeschlossene Klemme 19 an den positiven Pol einer Versorgungsspannungsquelle angeschlossen. Die am Brückenquerzweig anliegende Spannung (zwischen einer mit der Bezugselektrode 14 verbundenen Klemme 20 und dem Verknüpfungspunkt der beiden Widerstände 16, 17) ist einem Verstärker 21 zugeführt, der die verstärkte Brückenspannung einer Klemme 22 zuführt.

Im einfachsten Fall können im Lagesensor 10 auch nur zwei Elektroden vorgesehen sein, die einen einzigen, variablen Widerstand bilden, der mit drei anderen Festwiderständen eine Brückenschaltung bildet.

Die mit dem positiven Pol der Versorgungsspannungsquelle verbundene Klemme 19 ist weiterhin über einen Hauptschalter 23 zur Aktivierung der Alarmanlage mit dem Eingang eines Verzögerungsglieds 24, mit einem Eingang eines ODER-Gatters 25, mit dem Rücksetzeingang eines Flipflops 26 und schließlich mit einem Eingang eines ODER-Gatters 27 verbunden. Der Ausgang des Verzögerungsglieds 24, durch das eine eingangs angelegte Anstiegsflanke um die Zeit v1 verzöget wird, ist einmal mit dem Setzeingang eines Flipflops 28 und weiterhin mit einem Eingang eines UND-Gatters 29 sowie mit dem Rücksetzeingang eines digitalen Zählers 30 verbunden. Der Ausgang des UND-Gatters 29 ist an den Setzeingang des Flipflops 26 angeschlossen. Der Ausgang des Flipflops 28 ist über ein UND-Gatter 31 an den Takteingang C des Zählers 30 angeschlossen. Über eine Klemme 32 ist dem zweiten Eingang des UND-Gatters 31 eine Taktfrequenz zugeführt. Die Zahlenausgänge des digitalen Zählers 30 sind mit Zahleneingängen eines Digital-Analog-Wandlers 33 verbunden, dessen Ausgang an je einen Eingang eines Komparators 34 und eines Differenzverstärkers 35 angeschlossen ist. Beide Bauteile 34, 35 können z.B. durch einen Operationsverstärker realisiert sein. Der Ausgang des Komparators 34 ist sowohl über das ODER-Gatter 25 an den Rücksetzeingang des Flipflops 28, wie auch an einen zweiten Eingang des UND-Gatters 29 angeschlossen. Der Ausgang des Flipflops 26 ist über ein UND-Gatter 36 an den Setzeingang eines weiteren Flipflops 37 angeschlossen. Der Ausgang des ODER-Gatters 27 ist an den Rücksetzeingang dieses Flipflops 37 angeschlossen. Der Ausgang des Differenzverstärkers 35 ist über eine Begrenzungs-Einrichtung 54, ein Filter 55 sowie einen Fensterkomparator 38 mit dem zweiten Eingang des UND-Gatters 36 verbunden. Ein solcher Fensterkomparator 38 gibt ein Ausgangssignal ab, wenn eine obere Schwelle überschritten oder eine untere Schwelle unterschritten ist. Eine Realisierung kann z.B. durch zwei Schwellwertstufen erfolgen, deren Ausgänge über ein ODER-Gatter verknüpft sind. Der Ausgang des Flipflops 37 ist über die Reihenschaltung zweier Verzögerungsglieder 39, 40 an den zweiten Eingang des ODER-Gatters 27 angeschlossen. Dabei wird die Anstiegsflanke eines Ausgangssignals des Flipflops 37 durch das Verzögerungsglied 39 um die Zeitspanne v2 verzögert, und die Anstiegsflanke des Ausgangssignals des Verzögerungsglieds 39 wird durch das Verzögerungsglied 40 wiederum um die Zeitspanne v3 verzögert. Der Ausgang des Verzögerungsglieds 39 ist mit einer akustischen und optischen Warneinrichtung 41, 42 verbunden. Die akustische Warneinrichtung 41 kann dabei z.B. die Hupe und die optische Warneinrichtung 32 kann z.B. der Scheinwerfer in einem Kraftfahrzeug sein.

Die Wirkungsweise des in Fig. 1 dargestellten Ausführungsbeispiels soll im folgenden anhand des in Fig. 2 dargestellten Signaldiagramms erläutert werden. Die Wirkungsweise der Begrenzungs-Einrichtung 54 und des Filters 55 wird im Zusammenhang mit der Beschreibung zu Figur 3 dort noch näher erläutert. Es wird davon ausgegangen, daß die Setz- und Rücksetzeingänge der verwendeten Bauteile als dynamische Eingänge ausgebildet sind, die auf Signalanstiegsflanken ansprechen. Die Rücksetzeingänge der Flipflops 26, 37 sprechen zusätzlich noch auf Signalrückflanken an. Für die Realisierung der Schaltung müssen entweder handelsübliche Bauelemente verwendet werden, die solche dynamischen Eingänge aufweisen, oder es müssen gewöhnlich als RC-Glieder ausgebildete Dynamik-Glieder den Eingängen der betreffenden Bauteile vorgeschaltet sein.

Durch Schließen des Hauptschalters 23 wird ein Signal U23 an den Eingang des Verzögerungsglieds 24 angelegt, das an dessen Ausgang um die Zeitspanne v1 verzögert als Signal U24 erscheint. Durch die Anstiegsflanke des Signals U23 werden die Flipflops 28, 26, 37 rückgesetzt.

Durch die Anstiegsflanke des Signals U24 wird der Zähler 30 rückgesetzt und das Flipflop 28 gesetzt, wodurch an dessen Ausgang ein Signal U28 erzeugt wird. Durch dieses Signal U28 wird das UND-Gatter 31 für die an der Klemme 32 anliegenden Taktsignale durchlässig. Diese Taktsignale werden im Zähler 30 hochgezählt, wodurch am Ausgang des Digital-Analog-Wandlers 33 eine ansteigende Spannung U33 erzeugt wird. Diese Spannung U33 steigt solange an, bis ein Spannungswert erreicht ist, der der verstärkten Brückenspannung U22 der Brückenschaltung 13 bis 17 entspricht. Diese verstärkte Brückenspannung U22 liegt über die Klemme 22 am Vergleichseingang des Komparators 34 an. Bei Gleichheit der Eingangsspannungen erzeugt dieser Komparator 34 ein Ausgangssignal, durch das über das ODER-Gatter 25 das Flipflop 28 rückgesetzt und das Flipflop 26 über das UND-Gatter 29 gesetzt wird. Das Rücksetzen des Flipflops 28 bewirkt ein Ende des Zählvorgangs im Zähler 30. Der erreichte Zahlenwert bleibt gespeichert, wodurch am Ausgang des Digital-Analog-Wandlers 33 die Spannung U22 konstant anliegt. Das Verzögerungsglied 24 hat die Aufgabe, z.B. dem Fahrer eines Kraftfahrzeugs, in dem die Alarmanlage eingebaut ist, nach Aktivierung der Alarmanlage Gelegenheit zum Aussteigen zu geben, bevor die Einspeicherung der augenblicklichen Lage des Fahrzeugs beginnt. Dies ist deshalb erforderlich, da sich die Lage des Fahrzeugs beim Aussteigen des Fahrers noch einmal verändert. Die erforderliche Verzögerungszeit v1 kann z.B. zwei Minuten betragen. Erst nach dieser Zeit beginnt somit der Einspeichervorgang.

Wird nun die Lage des Lagesensors 10 verändert, z.B. durch unerlaubtes Eindringen in das Fahrzeug, durch Aufprall eines anderen Fahrzeugs oder durch weitere Ursachen, so ändert sich infolge der geänderten Neigung des Flüssigkeitspegels der Flüssigkeit 12 im Lagesensor 10 die Brückenspannung und an der Klemme 22 verändert sich das Signal U22, wie es im Diagramm zum Zeitpunkt t1 dargestellt ist. Wenn diese Veränderung so groß ist, daß eine der beiden Schwellen des Fensterkomparators 38 überschritten wird, so wird durch das dadurch erzeugte Signal U38 über das UND-Gatter 36 das Flipflop 37 gesetzt. Ein solches Signal U38 entstand auch schon während des Einspeichervorgangs in den Zähler 30. Zu dem Zeitpunkt konnte jedoch das Flipflop 37 noch nicht gesetzt werden, da das UND-Gatter 36 durch das O-Signal am Ausgang des Flipflops 26 gesperrt war. Das nunmehr am Ausgang des Flipflops 37 erzeugte Signal U37 wird durch das Verzögerungsglied 39 um die Zeitspanne v2 verzögert. Das nach dieser Verzögerungszeit entstehende Signal U39 löst den Alarm durch Ansteuerung der Warneinrichtungen 41, 42 aus. Die Anstiegsflanke des Signals U39 wird im Verzögerungsglied 40 verzögert, wodurch nach dieser Verzögerungszeit v3 ein Signal U40 erzeugt wird, durch das das Flipflop 37 rückgesetzt wird. Die Verzögerungszeit des Verzögerungsglieds 40 gibt somit die Dauer des Alarms vor, der in vielen Ländern gesetzlich begrenzt ist. Die Verzögerungszeit des Zeitglieds 39 hat die Aufgabe, der in das Fahrzeug einsteigenden berechtigten Person Gelegenheit zu geben, durch Öffnen des Schalters 23 durch Rücksetzen der Flipflops 28, 26, 37 die Alarmanlage abzuschalten. Zu diesem Zweck kann die Verzögerungszeit v2 z.B. 15 Sekunden betragen.

Anstelle der direkten Ansteuerung der Warneinrichtung 41, 42 durch das Signal U39 kann diese Ansteuerung auch über einen nicht näher dargestellten Frequenzgenerator erfolgen, sofern ein intermittierendes Warnsignal erwünscht ist.

Durch Einstellen der Schwellen des Fensterkomparators 38 läßt sich die Empfindlichkeit der Anlage einstellen. Eine zu große Empfindlichkeit ist dabei nicht wünschenswert, da äußere Einflüsse, wie z.B. ein vorbeifahrender Lastzug, ein Windstoß oder spielende Kinder die Alarmanlage nicht auslösen sollen.

Eine Erhöhung der Anzeigesicherheit kann dadurch erreicht werden, daß z.B. zwei Lagersensoren 10 senkrecht zueinander angeordnet werden. Dadurch können sämtliche Neigungen des Fahrzeugs erfaßt werden. Die Speichereinrichtung oder wenigstens der Komparator 34 und die Differenzverstärker 35 müßten dann doppelt ausgeführt und ausgangsseitig verknüpft sein. Entsprechend müßten in Fig. 3 wenigstens die Bauteile 51 bis 53 und Fig. 4 vollständig doppelt ausgeführt sein.

Das Ausgangssignal des Differenzverstärkers 35 läßt sich auch zur Anzeige der Beschleunigung des Fahrzeugs verwenden. Dazu kann vor Start des Fahrzeugs der Hauptschalter 23 kurzzeitig ein- und ausgeschaltet werden, so daß zwar die augenblickliche Neigung des Fahrzeugs im Zähler 23 gespeichert wird, eine auslösende Alarmanlage jedoch verhindert wird. Durch die beschleunigungsabhängige Veränderung des Flüssigkeitspegels der Flüssigkeit 12 wird am Ausgang des Differenzverstärkers 35 ein beschleunigungsproportionales Signal erzeugt, das z.B. mit Hilfe eines Meßinstruments angezeigt werden kann. In dem in Fig. 3 dargestellten zweiten Ausführungsbeispiel ist eine mit dem Ausgang des Verzögerungsglieds 24 verbundene Klemme 50 an den Setzeingang S einer digitalen Speichereinrichtung 51 angeschlossen. Eine solche Speichereinrichtung kann ein RAM oder ein digitaler Zähler sein. Die Klemme 22 ist an den Eingang eines Analog-Digital-Wandlers 52 angeschlossen, dessen Zahlenausgänge sowohl mit Zahleneingängen der Speichereinricht 51, wie auch mit Eingängen A einer Subtra stufe 53 verbunden sind. Die Zahlenausgänge der Speichereinrichtung 51 sind mit Eingängen B der Subtrahierstufe 53 verbunden. Die Zahlenausgänge A-B sind an die Eingänge einer Begrenzungs-Einrichtung 54 angeschlossen. Der Ausgang der Begrenzungs-Einrichtung 54 ist über ein Filter 55 und eine Betragsbildungsstufe 56 an erste Eingänge eines digitalen Komparators 57 angeschlossen; an dessen Vergleichszahleneingänge, vorzugsweise durch feste Verdrahtung, der Zahlenwert X angelegt ist. Ausgangsseitig ist der Komparator 57 an einen Eingang des UND-Gatters 36 gemäß Fig. 1 angeschlossen. Unter Wegfall der Bauteile 25, 28 bis 34 kann die übrige, nicht dargestellte Schaltung dem in Fig. 1 dargestellten Ausführungsbeispiel entsprechen. Die Klemme 50 ist dabei direkt mit dem Setzeingang des Flipflops 26 verbunden.

Die Wirkungsweise der in Fig. 3 dargestellten digitalen Schaltungsversion besteht darin, daß mit der Anstiegsflanke eines Signals U24 ein der Brückenspannung der Brückenschaltung 13 bis 17 entsprechender digitaler Zahlenwert in die Speichereinrichtung 51 übernommen wird. Da zu diesem Zeitpunkt A gleich B ist, liegt an den Zahlenausgängen der Substrahierstufe 53 der Zahlenwert Null an. Ändert sich durch Lageveränderung des Lagesensors 10 der digitale Zahlenwert an den Eingängen A der Subtrahierstufe 53, so wird ein der Abweichung entsprechender Zahlenwert über die Bauteile 54 bis 56 dem Komparator 57 zugeführt und mit dem festen Zahlenwert X verglichen. Übersteigt die Abweichung (begrenzter und gefilterter Betrag A-B) den Zahlenwert X, so wird gemäß dem ersten Ausführungsbeispiel ein Ausgangssignal erzeugt. Ist dieses Ausgangssignal von längerer Dauer, so löst es — praktisch unbehelligt vom Filter 55 — über das UND-Gatter 36 einen Alarm aus. Ist dieses Ausgangssignal jedoch von sehr kurzer Dauer, so wird dieses kurzzeitige Signal im Filter 55 (Tiefpaßfilter) weggefiltert. Solche kurzzeitigen Signale, die z.B. durch Schaukeln der Karosserie eines Kraftfahrzeugs durch Kinder oder Windstöße verursacht sein können, sollen natürlich einen Alarm nicht auslösen. Die Begrenzungseinrichtung 54 ist z.B. ein digitaler Zwischenspeicher bzw. Zähler, der nur Zahlenwerte bis zu einem bestimmten Wert einspeichern kann und höhere Zahlenwerte dadurch ignoriert, wodurch eine Begrenzung zustande kommt. Sie dient dazu, zu verhindern, daß auch bei sehr starken Karosserieschwankungen ein Alarmsignal ausgelöst wird, indem diese großen Werte dennoch über das Filter 55 gelangen könnten. Eine Auslösung soll insgesamt schon bei kleinen Abweichungen erfolgen, jedoch nur dann, wenn diese von längerer Dauer sind, z.B. beim Aufbocken des Fahrzeugs zur Demontage der Räder. Ist jedoch eine Auslösung der Alarmanlage schon bei kurzzeitigen Lageveränderungen erwünscht, so können natürlich Begrenzung und Filterung entfallen.

In Fig. 4 ist ein weiteres Ausführungsbeispiel für eine Lageerfassung gezeigt. Der Lagesensor 10 ist als sogenanntes Kurzschlußringgeber-System aufgebaut, wie es für sich z.B. aus der DE-OS 2 352 851, und in Kombination mit einem Oszillator aus der DE-OS 2 357 791 und der DE-OS 2 416 237 bekannt ist. Dort sind Prinzip und Wirkungsweise eines solchen Kurzschlußringgeber-Systems ausführlich beschrieben. Im vorliegenden Fall besteht dieses Kurzschlußringgebersystem aus einem E-Magnetkern 58, auf dessen mittlerem Schenkel eine Magnetwicklung 59 aufgebracht ist. Ein als kurzes, gebogenes Rohrstück ausgebildeter Kurzschlußring 60 ist an einer Achse in einer Horizontale drehbar gelagert, und zwar so, daß in Abhängigkeit der Neigung der zu sichernden Vorrichtung, mit der der Magnetkern 58 starr verbunden ist, dieser mehr oder weniger in den Kurzschlußring 60 eintaucht. Die Lagerung der Achse sollte dabei reibungsarm erfolgen, um auch sehr kleine Winkeländerungen erfassen zu können. Zur hydraulischen Bedämpfung ist das ganze Gebersystem 10 vorzugsweise in Silikonöl eingetaucht, um z.B. bei starken Karosserieschwankungen nur geringfügige Schwankungen des Kurschlußrings 60 zu erreichen. Dies soll verhindern, daß der Kurzschlußring-Geber im nichtlinearen Bereich seiner Kennlinie betrieben wird. Die beiden Anschlüsse der Wicklung 59 sind mit einem Oszillator 61 verbunden. Die Induktivität der Wicklung 59, die sich in Abhängigkeit der Lage des Kurzschlußringes 60 relativ zum Kern 58 ändert, bildet dabei das frequenzbestimmende Glied des Oszillators 61. Eine solche Anordnung ist im angegebenen Stand der Technik gezeigt. Der Ausgang des Oszillators 61 ist mit dem Takteingang eines Zählers 62 verbunden, dessen Zahlenausgänge einer Speichereinrichtung 63 zugeführt sind. Der Ausgang eines Zeittaktgebers 64 ist sowohl mit dem Rücksetzeingang des Zählers 62, wie auch mit dem Setzeingang der Speichereinrichtung 63 verbunden. Die Zahlenausgänge dieser Speichereinrichtung 63 sind der Speichereinrichtung 51 und der Subtrahierstufe 53 gemäß Fig. 3 zugeführt. Da der lageabhängige Speicherwert nunmehr direkt als Zahlenwert vorliegt, kann der Analog-Digital-Wandler 52 natürlich entfallen.

Die Wirkungsweise der in Fig. 4 dargestellten Anordnung besteht darin, daß sich durch die lageabhängige Veränderung der Induktivität der Wicklung 58 die Frequenz des Frequenzgenerators 61 ändert. Die Ausgangssignale dieses Frequenzgenerators 61 werden im Zähler 62 gezählt, bis jeweils vom Zeittaktgeber 64 ein Rücksetzsignal erzeugt wird. Ab einem solchen Signal beginnt der Zählvorgang erneut. Jeweils kurz vor einem Rücksetzsignal wird der erreichte Zählerstand im Zähler 62 in den Speicher 63 übernommen. Hierzu kann es erforderlich sein, daß das Rücksetzsignal für den Zähler 62 durch ein nicht näher dargestelltes Verzögerungsglied geringfügig verzögert wird. In der Speichereinrichtung 63 liegt somit immer ein aktuelles, von der Lage abhängiges Signal vor.

Die in Fig. 4 gezeigte Anordnung kann natürlich auch für das Ausführungsbeispiel gemäß Fig. 1 verwendet werden. In diesem Falle kann der Digital-Analog-Wandler 33 entfallen und der Komparator 34 muß als digitaler Komparator ausgeführt sein. Der Fensterkomparator 38 muß ebenfalls digital realisiert sein, z.B. gemäß der Anordnung 53, 54 in Fig. 3.

Das digital realisierte Ausführungsbeispiel läßt sich auch vorteilhaft durch einen Mikrorechner realisieren.

Um einer Langzeitveränderung der Lage der zu sichernden Vorrichtung, also z.B. des Kraftfahrzeugs, Rechnung zu tragen, kann noch eine Zusatzeinrichtung vorgesehen werden. Eine solche langsame Veränderung der Lage tritt bei einem Kraftfahrzeug z.B. dadurch auf, daß ein asymmetrischer Schneebelag auf der Fahrzeugoberfläche langsam schmilzt. Durch das Signal U24 an der Klemme 50 kann zu diesem Zweck ein Taktgeber gesteuert werden, der eine sehr große Taktzeitfolge von z.B. einer Stunde aufweist. Damit wird jeweils nach einer Stunde ein neuer Einspeichervorgang der aktuellen Lage ausgelöst.

Der Referenzwert kann aber auch über ein digitales Verzögerungsglied erster Ordnung mit einer Zeitkonstante von z.B. einer Stunde laufend an den aktuellen Wert angepaßt werden.

**Ansprüche**

1. Alarmanlage, insbesondere für Kraftfahrzeuge, mit einem Lagesensor (10), der mit der zu sichernden Vorrichtung gekoppelt ist und dessen Signal bei Aktivierung der Anlage in einer Speichereinrichtung (30, 51) gespeichert wird, wobei bei einer festlegbaren Abweichung des Signals des Lagesensors (10) vom gespeicherten Wert (Referenzlage), eine akustische und/oder optische Warneinrichtung (41, 42) ausgelöst wird, dadurch gekennzeichnet, daß zwischen dem Lagesensor (10) und der Warneinrichtung (41, 42) ein Tiefpassfilter (55) angeordnet ist.

2. Alarmanlage nach Anspruch 1, dadurch gekennzeichnet, daß das der Abweichung von der Referenzlage entsprechende Signal durch eine Begrenzungseinrichtung (54) begrenzt wird.

3. Alarmanlage, insbesondere für Kraftfahrzeuge, mit einem Lagesensor (10), der mit der zu sichernden Vorrichtung gekoppelt ist und dessen Signal bei Aktivierung der Anlage in einer Speichereinrichtung (30, 51) gespeichert wird, wobei bei einer festlegbaren Abweichung der Signals des Lagesensors (10) vom gespeicherten Wert (Referenzlage), eine akustische und/oder optische Warneinrichtung (41, 42) ausgelöst wird, dadurch gekennzeichnet, daß ein Setz-Taktgeber vorgesehen ist, durch den in größeren Zeitabständen der Einspeichervorgang wiederholt wird.

4. Alarmanlage nach einem der vorhergehenden Ansprüche, dadurch gekennzeichnet, daß als Lagesensor (10) ein mit einer leitfähigen Flüssigkeit (12) teilweise gefülltes Gefäß (11) vorgesehen ist, das wenigstens zwei Elektroden (13, 15) aufweist, wobei der Widerstandswert zwischen den Elektroden (13, 15) in Abhängigkeit des Flüssigkeitspegels variiert.

5. Alarmanlage nach Anspruch 4, dadurch gekennzeichnet, daß drei Elektroden (13 bis 15) vorgesehen sind, wobei die Leitstrecke zwischen einer ersten Elektrode (14) und einer zweiten (13) als erster variabler Widerstand und die Leitstrecke zwischen der ersten Elektrode (14) und einer dritten (15) als zweiter variabler Widerstand Verwendung findet.

6. Alarmanlage nach Anspruch 4 oder 5, dadurch gekennzeichnet, daß der wenigstens eine variable Widerstand in eine Widerstands-Brückenschaltung (13 bis 17) geschaltet ist, wobei ein der am Brückenquerzweig anliegenden Spannung proportionaler Wert in die Speichereinrichtung (30, 51) einspeicherbar ist.

7. Alarmanlage nach einem der Ansprüche 1 bis 3, dadurch gekennzeichnet, daß als Lagesensor (10) ein Kurzschlußringgebersystem (58 bis 60) vorgesehen ist, bei dem der Kurzschlußring (60) reibungsarm um eine Achse drehbar gelagert ist und in Abhängigkeit der Lage der zu sichernden Vorrichtung in einem mit dieser Vorrichtung starr verbundenen, eine induktive Wicklung (59) aufweisenden Magnetkern (58) eintaucht.

8. Alarmanlage nach Anspruch 7, dadurch gekennzeichnet, daß der Magnetkern (58) als E-Kern ausgebildet ist und daß der Kurschlußring (60) über dem mittleren Schenkel bewegbar ist.

9. Alarmanlage nach Anspruch 7 oder 8, dadurch gekennzeichnet, daß wenigstens ein Teil des Kurzschlußringgebersystems in ein dämpfendes Medium, vorzugsweise Silikonöl, eingebettet ist.

10. Alarmanlage nach einem der Ansprüche 7 bis 9, dadurch gekennzeichnet, daß die induktive Wicklung (58) das frequenzbestimmende Element eines Oszillators (61) ist, dessen Frequenz zyklisch in einem Zeitraster gezählt wird, wobei das Zählergebnis das Lagesignal darstellt.

11. Alarmanlage nach einem der vorhergehenden Ansprüche, dadurch gekennzeichnet, daß die festlegbare Abweichung des Lagesignals vom gespeicherten Signal als Auslöekriterium dem Betrage nach durch eine Schwellwerteinrichtung (38 bzw. 57) bestimmt wird.

12. Alarmanlage nach einem der vorhergehenden Ansprüche, dadurch gekennzeichnet, daß die Warneinrichtung durch zwei Signalgeber-Anordnungen auslösbar ist, deren Lagesensoren auf zwei zueinander senkrechte Lageverschiebungen ansprechen.

13. Alarmanlage nach einem der vorhergehenden Ansprüche, dadurch gekennzeichnet, daß als Speichereinrichtung eine Zähleinrichtung (30) vorgesehen ist, wobei der Zählvorgang durch ein Aktivierungssignal der Anlage auslösbar ist und solange andauert, bis ein Wert erreicht ist, der als digitaler Wert dem des Lagesensors (10) entspricht.

14. Alarmanlage nach einem der Ansprüche 1 bis 12, dadurch gekennzeichnet, daß die Speichereinrichtung als digitaler Speicher (51) ausgebildet ist, wobei ein dem durch den Lagesensor vorgegebenen Wert entsprechender Zahlenwert auf ein Aktivierungssignal der Anlage hin in den digitalen Speicher (51) übernommen wird.

15. Alarmanlage nach einem der vorhergehenden Ansprüche, dadurch gekennzeichnet, daß das Aktivierungssignal verzögert wird.

16. Alarmanlage nach einem der vorhergehenden Ansprüche, dadurch gekennzeichnet, daß das bei einer festlegbaren Abweichung des Signals des Lagesensors (10) vom gespeicherten Signal erzeugte Auslösesignal ebenfalls verzögert wird.

17. Alarmanlage nach einem der vorhergehenden Ansprüche, dadurch gekennzeichnet, daß die Differenz zwischen dem im Ruhezustand gespeicherten Lagesignal und einem bei einer Beschleunigung auftretenden Lagesignal als Beschleunigungssignal angezeigt wird.

## Claims

1. An alarm system, especially for motor vehicles, comprising an attitude sensor (10) which is coupled to the device to be protected and the signal from which is stored in a storage device (30, 51) on activating the system, wherein on the occurrence of a determinable deviation of the signal from the attitude sensor (10) from the stored value (reference attitude) an acoustic and/ or optical warning device (41, 42) is triggered, characterised in that, a low pass filter (55) is arranged between the attitude sensor (10) and the warning device (41, 42).

2. An alarm system according to claim 1, characterised in that, the signal corresponding to the deviation from the reference attitude is limited by a limiting device (54).

3. An alarm system, especially for motor vehicles, comprising an attitude sensor (10) which is coupled to the device to be protected and the signal from which is stored in a storage device (30, 51) on activating the system, wherein on the occurrence of a determinable deviation of the signal from the attitude sensor (10) from the stored value (reference attitude) an acoustic and/ or optical warning device (41, 42) is triggered, characterised in that, a set pulse generator is provided through which the storage procedure is repeated at longer time intervals.

4. An alarm system according to one of the preceding claims, characterised in that, a chamber (11) partially filled with a conductive liquid (12) and having at least two electrodes (13, 15) is provided as an attitude sensor (10) wherein the resistance value between the electrodes (13, 15) varies in accordance with the liquid level.

5. An alarm system according to claim 4, characterised in that, three electrodes (13 to 15) are provided wherein the conductive path between a first electrode (14) and a second (13) is used as a first variable resistance and the conductive path between the first electrode (14) and a third (15) is used as a second variable resistance.

6. An alarm system according to claim 4 or 5, characterised in that, the at least one variable resistance is connected in a resistance bridge circuit (13 to 17) wherein a value proportional to the voltage at the bridge diagonal can be stored in the storage device (30, 51).

7. An alarm system according to one of claims 1 to 3, characterised in that, a shading ring generator system (58 to 60) is provided as an attitude sensor (10), in which the shading ring (60) is rotatably mounted about an axis in a friction free manner and in accordance with the attitude of the device to be protected, dips into a magnet core (58) rigidly connected to the said device and provided with an inductive winding (59).

8. An alarm system according to claim 7, characterised in that, the magnet core (58) is formed as an E-core and that the shading ring (60) is movable over the central limb.

9. An alarm system according to claim 7 or 8, characterised in that, at least a portion of the shading ring generator system is immersed in a damping medium, preferably silicon oil.

10. An alarm system according to one of claims 7 to 9, characterised in that, the inductive winding (59) is the frequency determining element of an oscillator (61) the frequency of which is counted cyclically in a time raster wherein the result of count represents the attitude signal.

11. An alarm system according to one of the preceding claims, characterised in that, the determinable deviation of the attitude signal from the stored signal is determined as a trigger criterion in accordance with the value by a threshold value device (38 or 57).

12. An alarm system according to one of the preceding claims, characterised in that, the warning device can be triggered by two signal generator arrangements the attitude sensors of which respond to two variations in attitude perpendicular to each other.

13. An alarm system according to one of the preceding claims, characterised in that, a counting device (30) is provided as a storage device wherein the counting procedure can be triggered by an activating signal for the system and continues until a value is reached which corresponds to the attitude sensor (10) as a digital value.

14. An alarm system according to one of claims 1 to 12, characterised in that, the storage device is formed as a digital store (51) wherein a numerical value corresponding to the value predetermined by the attitude sensor is transferred into the digital store (51) on an activating signal for the system.

15. An alarm system according to one of the preceding claims, characterised in that, the activating signal is delayed.

16. An alarm system according to one of the preceding claims, characterised in that, the trigger signal generated by a determinable deviation of the signal from the attitude sensor (10) from the stored signal is likewise delayed.

17. An alarm system according to one of the preceding claims, characterised in that, the difference between the attitude signal stored in the rest condition and an attitude signal occurring during an acceleration, is indicated as an acceleration signal.

## Revendications

1. Installation d'alarme, notamment pour véhicules automobiles, avec un détecteur de position (10) couplé avec le dispositif à garantir et dont le signal, lors de la mise en activité de l'installation, est stocké dans un dispositif à mémoire (30, 51), un dispositif avertisseur acoustique et/ou optique (41, 42) étant déclenché pour un écart décelable du signal du détecteur de position (10) vis-à-vis de la valeur en mémoire (position de référence), caractérisée en ce qu'un filtre passe-bas (55) est disposé entre le détecteur de position (10) et le dispositif avertisseur (41, 42).

2. Installation d'alarme selon la revendication 1, caractérisée en ce que le signal correspondant à l'écart vis-à-vis de l'installation de référence est limité par un dispositif limiteur (54).

3. Installation d'alarme, notamment pour véhicules automobiles, avec un détecteur de position (10) couplé avec le dispositif à garantir et dont le signal, lors de la mise en activité de l'installation, est stocké dans un dispositif à mémoire, un dispositif avertisseur acoustique et/ou optique (41, 42) étant déclenché pour un écart décelable du signal du détecteur de position (10) vis-à-vis de la valeur en mémoire (position de référence), caractérisée en ce qu'il est prévu un générateur de cadence de réglage par lequel le processus de mise en mémoire est répété à de grands intervalles de temps.

4. Installation d'alarme selon l'une des revendications précédentes, caractérisée en ce qu'il est prévu en tant que détecteur de position (10) un récipient (11) partiellement rempli avec un liquide conducteur (12), ce récipient comportant au moins deux électrodes (13, 15), la valeur de la résistance entre les électrodes (13, 15) variant en fonction du niveau du liquide.

5. Installation d'alarme selon la revendication 4, caractérisée en ce que trois électrodes (13 à 15) sont prévues, le trajet conducteur entre une première électrode (14) et une seconde (13) étant utilisé comme première résistance variable et le trajet conducteur entre la première électrode (14) et une troisième (15) étant utilisé comme seconde résistance variable.

6. Installation d'alarme selon la revendication 4 ou 5, caractérisée en ce qu'au moins une résistance variable est branchée dans un montage de résistances en pont (13 à 17), une valeur proportionnelle à la tension qui règne sur la branche transversale du pont pouvant être stockée dans le dispositif à mémoire (30, 51).

7. Installation d'alarme selon l'une des revendications 1 à 3, caractérisée en ce qu'il est prévu en tant que détecteur de position (10) un système capteur à anneau en court-circuit (58 à 60), dans lequel l'anneau en court-circuit (60) est monté pour tourner avec un faible frottement autour d'un axe et s'engage, en fonction de la position du dispositif à garantir, sur un noyau magnétique (58) assemblé rigidement avec ce dispositif et comportant un enroulement inductif (59).

8. Installation d'alarme selon la revendication 7, caractérisée en ce que le noyau magnétique (58) est agencé en tant que noyau en E et en ce que l'anneau en court-circuit (60) est déplaçable sur la branche médiane.

9. Installation d'alarme selon la revendication 7 ou 8, caractérisée en ce qu'au moins une partie du système capteur à anneau en court-circuit est noyée dans un milieu amortisseur, de préférence de l'huile aux silicones.

10. Installation d'alarme selon l'une des revendications 7 à 9, caractérisée en ce que l'enroulement inductif (59) est l'élément déterminant la fréquence d'un oscillateur (61) dont la fréquence est comptée de façon cyclique dans une grille de temps, le résultat de comptage constituant le signal de position.

11. Installation d'alarme selon l'une des revendications précédentes, caractérisée en ce que l'écart décelable du signal de position vis-à-vis du signal en mémoire est déterminé en tant que critère de déclenchement, d'après sa valeur, par un dispositif à valeur de seuil (38, 57).

12. Installation d'alarme selon l'une des revendications précédentes, caractérisée en ce que le dispositif avertisseur peut être déclenché par deux dispositifs émetteurs de signaux, dont les détecteurs de position répondent à deux déplacements de position perpendiculaires.

13. Installation d'alarme selon les revendications précédentes, caractérisée en ce qu'un dispositif de comptage (30) est prévu en tant que dispositif à mémoire, le processus de comptage pouvant être déclenché par un signal de mise en activité de l'invention et durant jusqu'à ce que soit atteinte une valeur correspondant, en tant que valeur numérique, à celle du détecteur de position (10).

14. Installation d'alarme selon l'une des revendications 1 à 12, caractérisée en ce que le dispositif à mémoire est agencé en tant que mémoire numérique (51), une valeur numérique correspondant à la valeur prédéterminée par le détecteur de position étant reprise dans la mémoire numérique (51) sur un signal de mise en activité de l'installation.

5. Installation d'alarme selon l'une des revendications précédentes, caractérisée en ce que le signal de mise en activité est retardé.

16. Installation d'alarme selon l'une des revendications précédentes, caractérisée en ce que le signal de déclenchement produit lors d'un écart décelable du signal du détecteur de position (10) vis-à-vis du signal en mémoire est également retardé.

17. Installation d'alarme selon l'une des revendications précédentes, caractérisée en ce que la différence entre le signal de position mis en mémoire à l'état de repos et un signal de position se produisant lors d'une accélération est indiquée en tant que signal d'accélération.

FIG 1

FIG 2

# FIG.3

# FIG.4